Europäisches Patentamt

European Patent Office

Office européen des brevets

(19)

(11) Publication number: **0 544 224 A2**

## EUROPEAN PATENT APPLICATION

(12)

(21) Application number: **92119980.8**

(22) Date of filing: **24.11.92**

(51) Int. Cl.5: **H03K 19/003**

(30) Priority: **25.11.91 JP 308685/91**

(43) Date of publication of application:
**02.06.93 Bulletin 93/22**

(84) Designated Contracting States:
**DE FR GB IT**

(71) Applicant: **Kabushiki Kaisha Toshiba
72, Horikawa-cho Saiwai-ku
Kawasaki-shi(JP)**

(72) Inventor: **Kinugasa, Masanori, c/o Int.
Property Division
K.K. Toshiba, 1-1-, Shibaura 1-chome
Minato-ku, Tokyo 105(JP)**
Inventor: **Nonaka, Satoshi, c/o Int. Property
Division
K.K. Toshiba, 1-1-, Shibaura 1-chome
Minato-ku, Tokyo 105(JP)**
Inventor: **Shigehara, Hiroshi, c/o Int. Property
Division
K.K. Toshiba, 1-1-, Shibaura 1-chome
Minato-ku, Tokyo 105(JP)**

(74) Representative: **Lehn, Werner, Dipl.-Ing. et al
Hoffmann, Eitle & Partner Patentanwälte
Arabellastrasse 4
W-8000 München 81 (DE)**

(54) **Input circuit.**

(57) According to this invention, the source, drain, and gate of a transistor (50) are connected to a power supply terminal (51), an output terminal (52), and a node (n1), respectively. The drain, source, and gate of an n-channel MOS transistor (53) are connected to the output terminal (52), a ground terminal (54), and a node (n2), respectively. One end of a resistor (55) and one end of a capacitor (Cpa) are connected to the node (n1), the other end of the resistor (55) is connected to an input terminal (56), and the other end of the capacitor (Cpa) is connected to the power supply terminal (51). One end of a resistor (57) and one end of a capacitor (Cna) are connected to the node (n2), the other end of the resistor (57) is connected to the input terminal (56), and the other end of the capacitor (Cna) is connected to the ground terminal (54).

FIG. 8

EP 0 544 224 A2

The present invention relates to an input circuit formed in a semiconductor integrated circuit and, more particularly, to an input circuit constituted by a CMOS transistor.

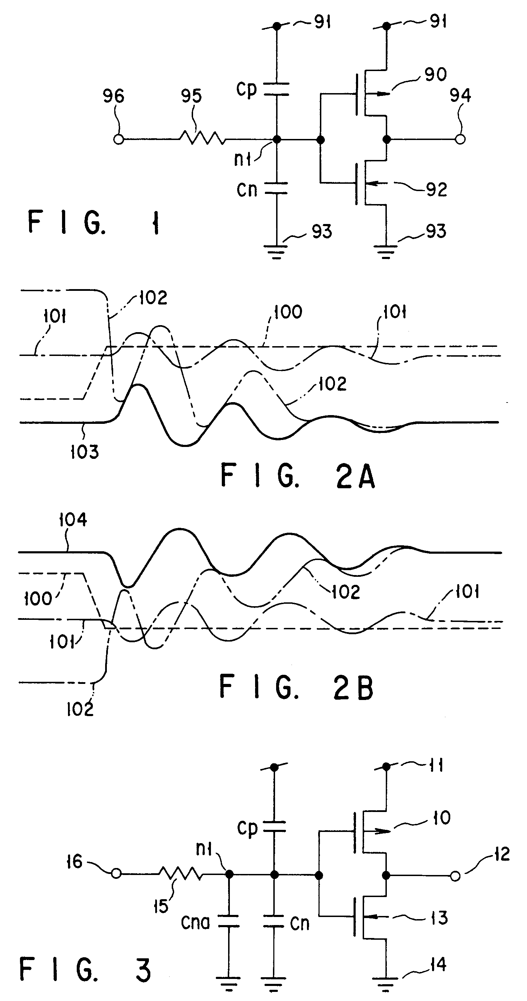

A conventional input circuit in a semiconductor integrated circuit is arranged as shown in Fig. 1. In Fig. 1, the source and gate of a p-channel MOS transistor 90 are connected to a power supply terminal 91 and a node n1, respectively. The drain of the p-channel MOS transistor 90 is connected to an output terminal 94. The source and gate of an n-channel MOS transistor 92 are connected to a ground terminal 93 and the node n1, respectively. The drain of the n-channel MOS transistor 92 is connected to the output terminal 94. One end of a protection resistor 95 for preventing the transistors 90 and 92 from breakdown caused by static electricity is connected to the node n1, and the other end of the protection resistor 95 is connected to an input terminal 96. A capacitor Cp is parasitic between the node n1 and the power supply terminal 91, and a capacitor Cn is parasitic between the node n1 and the ground terminal 93.

When the potential of an input signal input to the input terminal 96 of the input circuit is changed from high level to low level or changed from low level to high level, a change in potential of an output signal which appears from the output terminal 94 was measured by observing the waveform of the output signal. After the potential of the input signal was changed, when the potential is stabilized at a level slightly higher than the threshold value of the input circuit, it was observed that the output signal was oscillated. The oscillation of the output signal is shown in Figs. 2A and 2B. Fig. 2A shows a change in potential of an output signal 102 and a change in potential 103 of the ground terminal 93 which are obtained when the potential of an input signal 100 is changed from low level to high level and stabilized at a level slightly higher than a threshold voltage 101 of the input circuit. Fig. 2B shows a change in potential of the output signal 102 and a change in potential 104 of the power supply terminal 91 which are obtained when the potential 100 of the input signal is changed from high level to low level and stabilized at a level slightly higher than the threshold voltage 101 of the input circuit. Note that the waveforms of the threshold voltage 101 in Figs. 2A and 2B are drawn almost depending on the change in potential 103 of the ground terminal 93 and the change in potential 104 of the power supply terminal 91, but are not observed.

The reason for oscillating the output signal 102 will be described as follows. First, a case wherein the potential of the input signal 100 rises from low level will be described below. When the potential of the input signal 100 rises and exceeds the threshold voltage 101, the transistor 90 is turned off, and the transistor 92 is turned on. At this time, the potential of the output terminal 94 is set at high level because the capacitance of a circuit (not shown) connected to the output terminal 94 is charged in advance. Therefore, the potential of the source of the transistor 92 goes to high level, and a voltage is quickly applied across both the ends of a line between the source and the ground terminal 93. When the impedance of this line includes an inductance and a capacitance, since the voltage applied across both the ends of the line is oscillated, the potential 103 of the ground terminal 93 when viewed from the source of the transistor 92 is rippled. The threshold voltage 101 of the input circuit when viewed from the input terminal 96 is rippled almost in synchronism with the ripple of the potential 103 of the ground terminal 93. At this time, the potential of the input signal 100 which has risen is stabilized at a level slightly higher than the stabilized threshold voltage 101. For this reason, since the potential of the input signal when viewed from the rippled threshold voltage 101 is alternately changed between positive and negative states, the output signal 102 is oscillated.

A case wherein the potential of the input signal 100 falls from high level will be described below. When the potential of the input signal 100 falls and is lower than the threshold voltage 101, the transistor 90 is turned on, and the transistor 92 is turned off. At this time, the potential of the output terminal 94 is set at low level because the capacitance of a circuit (not shown) connected to the output terminal 94 is discharged. Therefore, the potential of the source of the transistor 90 goes to low level, and a voltage is quickly applied across both the ends of a line between the source and the power supply terminal 91. As is similar to the case wherein the potential of the input signal 100 rises, when the impedance of this line includes an inductance and a capacitance, the potential 104 of the power supply terminal 91 when viewed from the source of the transistor 90 is rippled, and the threshold voltage 101 is rippled. Since the potential of the input signal 100 is stabilized at a level slightly lower than the stabilized threshold voltage 101, the output signal 102 is oscillated.

The oscillation of the output signal 102 does not occur when the potential of the input signal 100 varies by an amount equal to that of the variation in threshold voltage 101, because the potential of the input signal 100 does not exceed the threshold voltage 101 again by a ripple once it exceeds the threshold voltage 101. In the above input circuit, the variation in potential of the ground terminal 93 which causes the variation in threshold voltage 101 gives an influence on the potential of the input signal 100. This influence is quantitatively expressed as follows.

The AC component of a distortion voltage superposed on the potential of the ground terminal 93 which causes a ripple is represented by Vx, and the AC component of the distortion voltage superposed on the input signal 100 at the node n1 is represented by Va. In addition, an angular frequency of each of the AC components is represented by ω, and the impedance on the input terminal 96 side when viewed from the node n1 is represented by Z. At this time, when the magnitude of the impedance Z is sufficiently larger than that of each of the reactances of the capacitors Cp and Cn, the AC component Va has a magnitude equal to a magnitude obtained by dividing the AC component Vx by these reactances. That is, when conditions of Z >> 1/(ωCn) and Z >> 1/(ωcp) are satisfied, the following equation is obtained:

$$Va = \frac{1/\omega Cp}{1/\omega Cn + 1/\omega Cp} Vx = \frac{Cn}{Cn + cp} Vx \qquad \ldots (1)$$

On the other hand, when the AC component Vx is an AC component superposed on the power supply terminal 91, the AC component Va is given by:

$$Va = \frac{1/\omega Cn}{1/\omega Cn + 1/\omega Cp} Vx = \frac{Cn}{Cn + Cp} Vx \qquad \ldots (2)$$

In the input circuit, when the magnitude of the AC component Va is close to the magnitude of the AC component Vx, the oscillation of the output signal caused by the above reason does not occur.

The present invention has been made in consideration of the above circumstances, and has as its object to provide an input circuit capable of preventing an output signal from being oscillated when the potential of an input signal is changed, and the changed potential is stabilized at a level slightly higher than the threshold voltage of the input circuit.

According to the present invention, there is provided an input circuit comprising a first channel MOS transistor having a source-drain path inserted between a first potential supply terminal and an output terminal and a gate for receiving an input signal through a first input resistor, and a second channel MOS transistor having a source-drain path inserted between the output terminal and a second potential supply terminal and a gate for receiving an input signal through a second input resistor.

A capacitor which is parasitic between a potential supply terminal and a gate causes a AC component of a distortion voltage generated by the potential supply terminal to feed back to an input signal.

This invention can be more fully understood from the following detailed description when taken in conjunction with the accompanying drawings, in which:

Fig. 1 is a circuit diagram showing a conventional input circuit;

Fig. 2A and 2B show potential variations generated during an operation of the conventional input circuit;

Fig. 3 is a circuit diagram according to a first embodiment of the present invention;

Fig. 4 show potential variations generated during an operation of the input circuit shown in Fig. 3;

Fig. 5 is a circuit diagram according to a second embodiment of the present invention;

Fig. 6 show potential variations generated during an operation of the input circuit shown in Fig. 5;

Fig. 7 is a circuit diagram according to a third embodiment of the present invention;

Fig. 8 show potential variations generated during an operation of the input circuit shown in Fig. 7;

Fig. 9 is a circuit diagram according to a fourth embodiment of the present invention; and

Fig. 10 is a circuit diagram according to a fifth embodiment of the present invention.

Embodiments of the present invention will be described below with reference to the accompanying drawings.

Fig. 3 is a circuit diagram showing an input circuit according to the first embodiment of the present invention. In Fig. 3, the source and drain of a p-channel MOS transistor 10 are connected to a power supply terminal 11 and an output terminal 12, respectively. In addition, the drain of an n-channel MOS transistor 13 is connected to the output terminal 12. The source of the transistor 13 is connected to a ground terminal 14. Both the gates of the transistors 10 and 13 are connected to a node n1. One end of a capacitor Cna and one end of a resistor 15 are connected to the node n1, the other end of the capacitor Cna is connected to the ground terminal 14, and the other end of the resistor 15 is connected to an input terminal 16. A capacitor Cp is parasitic between the node n1 and the power supply terminal 11, and a capacitor Cn is parasitic between the node n1 and the ground terminal 14.

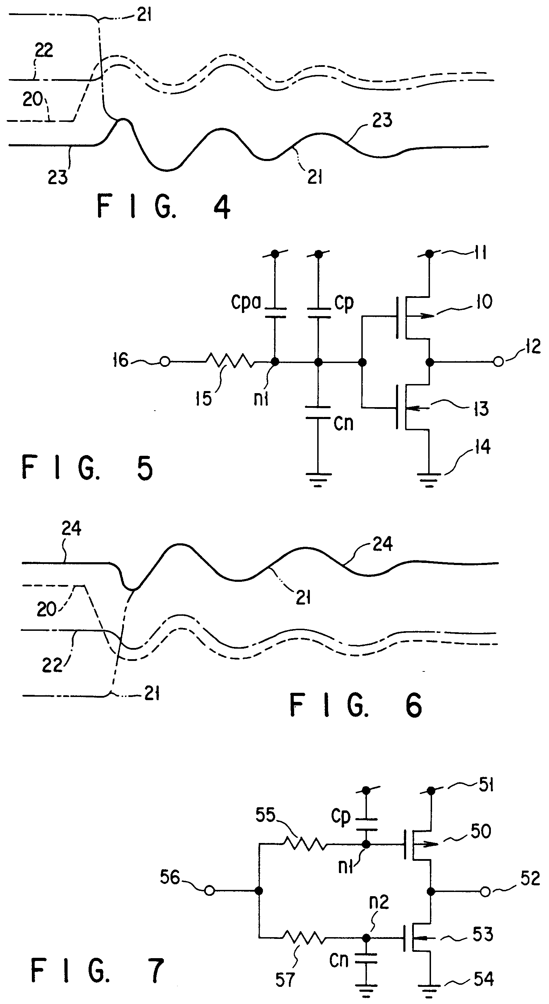

An operation of the input circuit having the above arrangement will be described below using the waveforms shown in Fig. 4. In Fig. 4, reference numeral 20 denotes the potential of an input signal input to the input terminal 16, and reference numeral 21 denotes the potential of an output signal which appears from the output terminal 12. Reference numeral 22 denotes the threshold voltage of the input circuit, and reference numeral 23 denotes the potential of the ground terminal 14. When the input signal potential 20 rises from low level and exceeds the threshold voltage 22, the transistor 10 is turned off, and the transistor 13 is turned on. At this time, a distortion voltage is generated by the ground terminal 14 due to the known reason, and the potential 23 is rippled. The threshold voltage 22 is rippled in synchronism with the ripple of the potential 23. The distortion voltage of the ground terminal 14 is superposed on the input signal 20 at the node n1. When each of a reactance generated by the capacitor Cp and a reactance generated by a synthesized capacitance consisting of the capacitor Cn and the capacitor Cna is sufficiently smaller than the impedance Z on the input terminal 16 side when viewed from the node n1, the magnitude of an AC component Va of the distortion voltage at the node n1 becomes equal to a magnitude obtained by dividing an AC component Vx of the distortion voltage in the ground terminal 14 by the above reactances. If an angular frequency of the AC component Vx is represented by $\omega$, a relationship between the components Va and Vx is given by:

$$Va = \frac{1/\omega Cp}{\frac{1}{\omega(Cn + Cna)} + \frac{1}{\omega Cp}} Vx = \frac{Cn + Cna}{Cn + Cna + Cp} Vx \qquad \ldots \quad (3)$$

For example, when a condition of Cp = 3Cn is satisfied, and the capacitor Cna is set to satisfy a condition of Cna = Cn, the magnitude of the AC component Va with respect to the AC component Vx in the conventional input circuit is given by equation (1) as follows:

Va = 1/4Vx    (4)

In addition, in the input circuit of the embodiment, a relationship between the AC components Va and Vx is given by equation (3) as follows:

Va = 2/5Vx    (5)

Therefore, in the circuit of the embodiment, the distortion voltage which is superposed on the ground terminal and has a magnitude larger than that of the conventional input circuit by about 15% can be superposed on the input signal. For this reason, although the potential of the input signal 20 which slightly exceeds the threshold voltage 22 once is stabilized at the input terminal 16, the potential of the input signal 20 follows the ripple of the potential 23 of the ground terminal 14 at the node n1 compared with the conventional input circuit. As a result, the oscillation of the output signal described using the Fig. 1 and the Figs. 2A and 2B does not occur.

Fig. 5 is a circuit diagram showing an input circuit according to the second embodiment of the present invention. Unlike the circuit of the embodiment in Fig. 3, in the circuit of the second embodiment, a capacitor Cna is not arranged, one end of a capacitor Cpa is connected to a node n1, and the other end of the capacitor Cpa is connected to a power supply terminal 11. Other arrangements than the above arrangement are the same as those of the circuit of the embodiment in Fig. 3. Fig. 6 shows waveforms of the operation of the circuit of the embodiment, and the same reference numerals as in Fig. 4 denote the same waveforms in Fig. 6. In Fig. 6, reference numeral 24 denotes a potential which appears from the power supply terminal 11.

In the circuit of the embodiment, when the potential of the power supply terminal 11 is rippled, and an impedance Z on an input terminal 16 side when viewed from the node n1 is sufficiently larger than each of the reactance of a capacitor Cn and the reactance of a synthesized capacitance consisting of a capacitor Cp and the capacitor Cpa, a relationship between an AC component Vx of the distortion voltage of the power supply terminal 11 which causes the above ripple and an AC component Va of the distortion voltage of the node n1 is given by following equation (6):

$$Va = \frac{1/\omega Cn}{\frac{1}{\omega Cn} + \frac{1}{\omega(Cp + Cpa)}} Vx = \frac{Cp + Cpa}{Cn + Cp + Cpa} \qquad \ldots \quad (6)$$

4

For example, when a condition of $Cp = 3Cn$ is satisfied, and the capacitor $Cpa$ is set to satisfy a condition of $Cpa = Cp$, the magnitude of the AC component $Va$ with respect to the AC component $Vx$ in the conventional input circuit is given by equation (2) as follows:

$Va = 3/4Vx$    (7)

In addition, in the circuit of the embodiment, a relationship between the AC components $Va$ and $Vx$ is given by equation (6) as follows:

$Va = 6/7Vx$    (8)

Therefore, according to the circuit of the embodiment, the distortion voltage which is superposed on the power supply terminal and has a magnitude larger than that of the conventional input circuit by about 10% can be superposed on an input signal. For this reason, although the potential of an input signal 20 which slightly exceeds a threshold voltage 22 once is stabilized at an input terminal 16, the potential of the input signal 20 follows the ripple of a potential 24 of the power supply terminal 11 at the node n1 compared with the conventional input circuit.

Fig. 7 is a circuit diagram showing an input circuit according to the third embodiment of the present invention. In Fig. 7, the source and drain of a p-channel MOS transistor 50 are connected to a power supply terminal 51 and an output terminal 52, respectively. In addition, the drain of an n-channel MOS transistor 53 is connected to the output terminal 52. The source of the transistor 53 is connected to a ground terminal 54. The gate of the transistor 50 is connected to a node n1, and a capacitor $Cp$ is parasitic between the node n1 and the power supply terminal 51. One end of a resistor 55 is connected to the node n1, and the other end of the resistor 55 is connected to an input terminal 56. The gate of the transistor 53 is connected to a node n2, and a capacitor $Cn$ is parasitic between the node n2 and the ground terminal 54. One end of a resistor 57 is connected to the node n2, and the other end of the resistor 57 is connected to the input terminal 56.

In the circuit of this embodiment, when the potential of the power supply terminal 51 is rippled, and an impedance $Zp$ on the input terminal 56 side when viewed from the node n2 is sufficiently larger than the reactance of a capacitor $Cp$, most of an AC component of a distortion voltage which causes the ripple is supplied from the capacitor $Cp$ to the node n1. Therefore, the potential of an input signal input to the input terminal 56 almost follows the ripple at the node n1. When an AC component of the distortion voltage of the power supply terminal 51 and an AC component of the distortion voltage of the node n1 are represented by $Vx$ and $Va$, respectively, and a condition of $Zp \gg 1/(\omega Cp)$ is satisfied, the following equation can be obtained:

$$Va = \frac{Zp}{Zp + \frac{1}{\omega Cp}} Vx = Vx \qquad \cdots (9)$$

Therefore, a potential difference between the gate and source of the transistor 50 is rarely changed. For this reason, the potential of an output signal which appears from the output terminal 52 is rarely changed.

In addition, when the potential of the ground terminal 54 is rippled, and an impedance $Zn$ on the input terminal 56 side when viewed from the node n2 is sufficiently larger than the reactance of a capacitor $Cn$, most of an AC component of a distortion voltage which causes the ripple is supplied to the node n2 by the capacitor $Cn$. Therefore, the potential of an input signal input to the input terminal 56 almost follows the ripple at the node n2. when the AC component of the distortion voltage of the ground terminal 54 and an AC component of the distortion voltage of the node n2 are represented by $Vx$ and $Va$, respectively, and a condition of $Zn \gg 1/(\omega Cn)$ is satisfied, the following equation can be obtained:

$$Va = \frac{Zp}{Zp + \frac{1}{\omega Cn}} Vx = Vx \qquad \cdots (10)$$

Therefore, a potential difference between the gate and source of the transistor 54 is rarely changed. For this reason, the potential of an output signal which appears from the output terminal 52 is rarely changed.

5

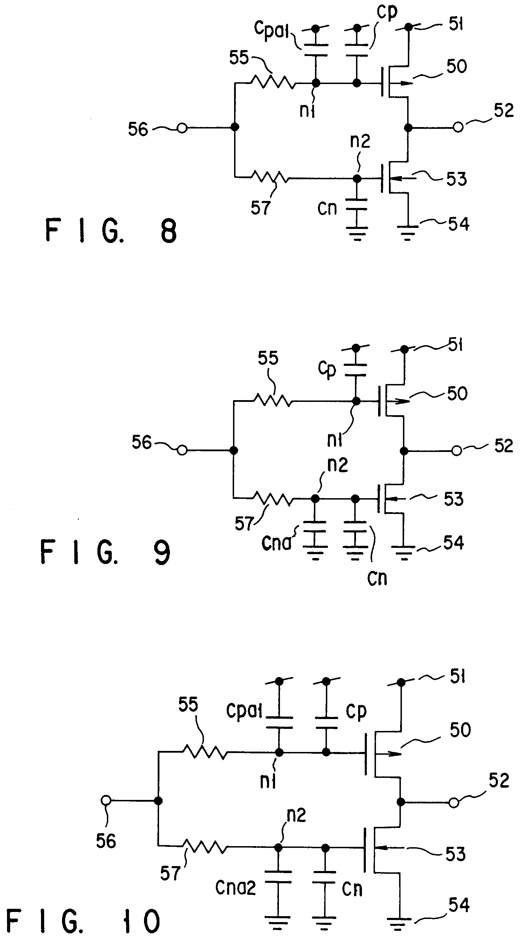

Fig. 8 is a circuit diagram showing an input circuit according to the fourth embodiment of the present invention. The circuit of this embodiment is obtained by adding a capacitor Cpa to the circuit of the embodiment in Fig. 7. One end of the capacitor Cpa is connected to a power supply terminal 51, and the other end of the capacitor Cpa is connected to a node n1. The magnitude of the capacitor Cpa is set such that a reactance generated by a synthesized capacitance of a capacitor Cp and the capacitor Cpa is sufficiently larger than an impedance Zp on an input terminal 56 side when viewed from the node n1.

In the circuit of this embodiment, when the potential of the power supply terminal 51 is rippled, most of the AC component of a distortion voltage which causes the ripple is supplied to the node n1 by the capacitors Cp and Cpa. Therefore, the potential of an input signal input to the input terminal 56 almost follows the ripple at the node n1.

Fig. 9 is a circuit diagram showing an input circuit according to the fifth embodiment of the present invention. The circuit of this embodiment is obtained by adding a capacitor Cna to the circuit of the embodiment in Fig. 7. One end of the capacitor Cna is connected to the ground terminal 54, and the other end of the capacitor Cna is connected to a node n2. The magnitude of the capacitor Cna is set such that a reactance generated by a synthesized capacitance of a capacitor Cn and the capacitor Cna is sufficiently larger than an impedance Zn on an input terminal 56 side when viewed from the node n2.

In the circuit of this embodiment, when the potential of the power supply terminal 54 is rippled, most of the AC component of the distortion voltage which causes the ripple is supplied to the node n2 by the capacitors Cn and Cna. Therefore, the potential of an input signal input to the input terminal 56 almost follows the ripple at the node n2.

Fig. 10 is a circuit diagram showing an input circuit according to the sixth embodiment of the present invention. The circuit of this embodiment is obtained by adding a capacitor Cpa in Fig. 8 and a capacitor Cna in Fig. 9 to the circuit of the embodiment in Fig. 7.

In the circuit of this embodiment, when the potential of a power supply terminal 51 is rippled, most of the AC component of the distortion voltage which causes the ripple is supplied to a node n1 by a capacitor Cp and the capacitor Cna. In addition, when the potential of a ground terminal 54 is rippled, most of the AC component of the distortion voltage which causes the ripple is supplied to a node n2 by a capacitor Cn and the capacitor Cna. Therefore, the potential of an input signal input to an input terminal 56 almost follows the ripple of the potential of the power supply terminal 51 at the node n1, and the potential of the input signal almost follows the ripple of the potential of the ground terminal 54 at the node n2.

As described above, according to the present invention, when the potential of an input signal is changed, and the changed potential is stabilized at a level slightly higher than the threshold voltage of an input circuit, an output signal can be prevented from being oscillated.

## Claims

1. An input circuit comprising:
    an input terminal (16, 56) for inputting a signal;
    signal converting means (10, 13, 50, 53) for receiving the signal and converting a level of the signal, said converting means (10, 13, 50, 53) arranged between first and second potential supply terminal (11, 51, 14, 54);
    an output terminal (12, 52) for outputting the converted signal; and
    a potential changing means (Cna, Cpa, 15, 55, 57) for changing a potential of the signal in response to a change in a threshold voltage of said signal converting means (10, 13, 50, 53) due to a potential change at first or second power supply terminal (11, 14, 51, 54).

2. An input circuit comprising:
    an input terminal (16) for inputting a signal;
    a signal converting means arranged between first and second potential supply terminal (51, 54), for receiving said signal and converting level of said signal, and having a first MOS transistor (50) of a first conductivity type and second MOS transistor (53) of a second conductivity type;
    an output terminal (52) for outputting said converted signal;
    a first resistor (55) arranged between said input terminal (56) and the gate of said first MOS transistor (50); and
    a second resistor (57) arranged between said input terminal (56) and the gate of said second MOS transistor (53).

6

**3.** An input circuit according to claim 2, characterized by further comprising a first capacitor (Cpa) connected between said first power supply terminal (51) and the node of said first resistor (55) and the gate of said first MOS transistor (50) and a second capacitor (Cna) connected between said second power supply terminal (54) and the node of said second resistor (57) and the gate of said second MOS transistor (53).

**4.** An input circuit according to claim 2, characterized by further comprising a capacitor (Cpa) connected between said first power supply terminal (51) and the node of said first resistor (55) and the gate of said first MOS transistor (50).

**5.** An input circuit according to claim 2, characterized by further comprising a capacitor (Cna) connected between said first power supply terminal (51) and the node of said second resistor (57) and the gate of said first MOS transistor (53).

**6.** An input circuit comprising:

an input terminal (16) arranged between first and second potential supply terminal (11, 14), for receiving said signal and converting level of said signal, for inputting a signal;

a signal converting means and having a first MOS transistor (10) of a first conductivity type and a second MOS transistor (13) of a second conductivity type;

an output terminal (12) for outputting the converted signal;

a resistor (15) which is arranged between said input terminal (16) and the gates of said first and second MOS transistors (10, 13); and

a capacitor (Cna) connected between said second power supply terminal (14) and the node of said resistor (15) and the gates of said first and second MOS transistors (10, 13).

**7.** An input circuit comprising:

an input terminal (16) for inputting a signal;

a signal converting means arranged between first and second potential supply terminal (11, 14), for receiving said signal and converting level of said signal, and having first MOS transistor (10) of a first conductivity type and a second MOS transistor (13) of a second conductivity type;

an output terminal (12) for outputting said converted signal;

a resistor (15) which is arranged between said input terminal (16) and the gates of said first and second MOS transistors (10, 13); and

a capacitor (Cpa) connected between said first power supply terminal (11) and the node of said resistor (15) and the gates of said first and second MOS transistors (10, 13).

F I G. 1

F I G. 2A

F I G. 2B

F I G. 3

F I G.  4

F I G.  5

F I G.  6

F I G.  7

F I G. 8

F I G. 9

F I G. 10